(19) Europäisches Patentamt
European Patent Office
Office européen des brevets

(11) Publication number: 0 078 173
B1

(12) EUROPEAN PATENT SPECIFICATION

(45) Date of publication of patent specification: 29.07.87

(51) Int. Cl.$^4$: H 01 L 21/31, H 01 L 21/60

(21) Application number: 82305660.1

(22) Date of filing: 25.10.82

# (54) Process for fabricating a semiconductor device having a phosphosilicate glass layer.

(30) Priority: 23.10.81 JP 169766/81

(43) Date of publication of application:
04.05.83 Bulletin 83/18

(45) Publication of the grant of the patent:
29.07.87 Bulletin 87/31

(84) Designated Contracting States:
DE FR GB

(56) References cited:
EP-A-0 034 483

(73) Proprietor: FUJITSU LIMITED
1015, Kamikodanaka Nakahara-ku
Kawasaki-shi Kanagawa 211 (JP)

(72) Inventor: Okano, Takashi
4-13-5 Fukasawa Setagaya-ku
Tokyo 158 (JP)

(74) Representative: Lawrence, Peter Robin Broughton et al
GILL JENNINGS & EVERY 53-64 Chancery Lane
London WC2A 1HN (GB)

EP 0 078 173 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to a process for fabricating a semiconductor device. In particular, it relates to treatment of the surface of a metal layer exposed by dry etching part of a phosphosilicate glass (PSG) layer covering the metal layer, the exposed metal layer being used for an electrical connection.

Many semiconductor devices having various types of circuit elements formed in a semiconductor substrate include a metal interconnection layer which connects an impurity doped layer, a gate electrode, or another component in the substrate to the exterior of the substrate or to the other circuit element in the substrate. Such a metal interconnection layer is often covered with a PSG layer as a protective layer or an insulating layer between metal layers. Such a PSG layer covering a metal layer is partly removed by etching so as to expose the underlying metal layer and to make a connection between the exposed area of the metal layer and the exterior or another circuit element of the substrate.

Recently, dry etching processes such as parallel plane-type plasma etching, ion beam etching, sputter etching, and so on have been used for etching PSG layers in order to increase the processing precision, simplify the treatment, or accomplish other purposes. However, a metal layer exposed by dry etching a PSG layer covering the metal layer may result in an insufficient electrical connection or may increase the contact resistance when a wire is bonded onto it or a connection through a via hole is made to it. If such an exposed metal surface is used as an electrode pad for wire bonding, the metal of the wire does not sufficiently alloy with the metal of the pad, sometimes resulting in separation of the wire from the pad. If a second metal layer is deposited on an insulating PSG layer covering a first metal layer as well as in a via hole formed by dry etching part of the PSG layer, i.e., the exposed area of the first metal layer, the contact between the two metal layers may not be electrically sufficient and may result in a disconnection with the passage of time.

It has been proposed to treat with a hydrofluoric acid solution the surface of a metal layer that has been exposed by dry etching a silicon dioxide ($SiO_2$) layer that covered the metal layer. However, this method is not very effective, and it concerns a $SiO_2$ layer and not a PSG layer. Also, as shown below, the treatment is not very satisfactory even if it is applied to a device having a PSG layer instead of an $SiO_2$ layer.

In the present invention a semiconductor device is made by a process comprising dry etching part of a PSG layer on a metal layer on a semiconductor substrate to expose at least part of the metal layer and treating the exposed surface of the metal layer with an alkaline solution.

The present invention is, in part, based on the discovery that when a metal layer covered by a PSG layer is exposed by dry etching the PSG layer, a phosphorus residue generally remains on the surface of the metal layer and that in order to obtain an excellent electrical connection at the exposed surface of the metal layer it is necessary to remove the phosphorus residue from the surface of the metal layer.

For example, in the case of reactive ion etching using fluoroform ($CHF_3$), a phosphorus residue is formed in the manner described below. The etching process is carried out by decomposing a PSG layer into silicon tetrafluoride ($SiF_4$), oxygen ($O_2$), and a phosphorus-containing substance whose chemical formula is not certain, all of these substances flying out of a workpiece to be etched. When the phosphorus flies out of the workpiece, it flies into a plasma atmosphere surrounding the workpiece, in which atmosphere ions are directed to the workpiece. As a result, the phosphorus is changed into plasma and is forced to run back toward the workpiece, and, consequently, a phosphorus residue is formed on the surface of the workpiece. The phosphorus residue includes not only phosphorus but also a small amount of carbon fluorine, etc.

The formation of a phosphorous residue on a metal layer by etching a PSG layer covering the metal layer occurs in the case of dry etching, for example, parallel plane-type plasma etching, ion etching, or sputter etching.

Although the phosphorus residue can be removed, for example, by treating it with an acid or hydrogen peroxide, such processes are not suitable for practical application since a large part of the metal layer is also removed simultaneous with removal of the phosphorus residue due to the corrosive properties of the metal, such as aluminium. Thus, an alkaline solution should be used, in accordance with the present invention, to remove the phosphorus residue from the metal layer. Alkalis such as ammonia; organic amines, for example, diethylamine ($Et_2NH$), triethylamine ($Et_3N$), dimethylamine ($Me_2NH$), trimethylamine ($Me_3N$), butylamine ($H_2N \cdot C_3H_7$),

choline $[HOCH_2CH_2\overset{+}{N}(CH_3)_3]OH^-$

and salts of organic amines, for example,

diethylamine hydrochloride ($Et_2\overset{+}{N}H_2Cl^-$),

triethylamine hydrochloride ($Et_3\overset{+}{N}HCHI^-$),

trimethylamine hydrochloride ($Me_3\overset{+}{N}HCl^-$),

butylamine hydrochloride ($H_2\overset{+}{N} \cdot C_3H_7HCl^-$),

preferably are used in the process of the present invention. Hydroxides of an alkali metal, such as sodium hydroxide and potassium hydroxide, and hydroxides of an alkali earth metal, such as calcium hydroxide, may be used to remove the phosphorus residue from the metal layer. However, these hydroxides are disadvantageous since solutions of them may cause contamination of a semiconductor device, as is known.

Metals which can be advantageously used in the process of the present invention include aluminium, aluminium-based alloy, molybdenum, molybdenum-based alloy, tungsten, tungsten-based alloy, tantalum, a tantalum-based alloy, titanium, titanium-based alloy, niobium, and niobium-based alloy.

The present invention is more fully described with reference to the accompanying drawings, in which:

Figure 1 is a sectional view of part of a semiconductor device where a wire is bonded onto an electrode pad;

Figure 2 is a plan view of a portion of the electrode pad in Figure 1;

Figure 3 is a sectional view taken along the line III—III in Figure 2; and

Figure 4 is a sectional view of a part of a semiconductor device where two metal layers are connected through a via hole.

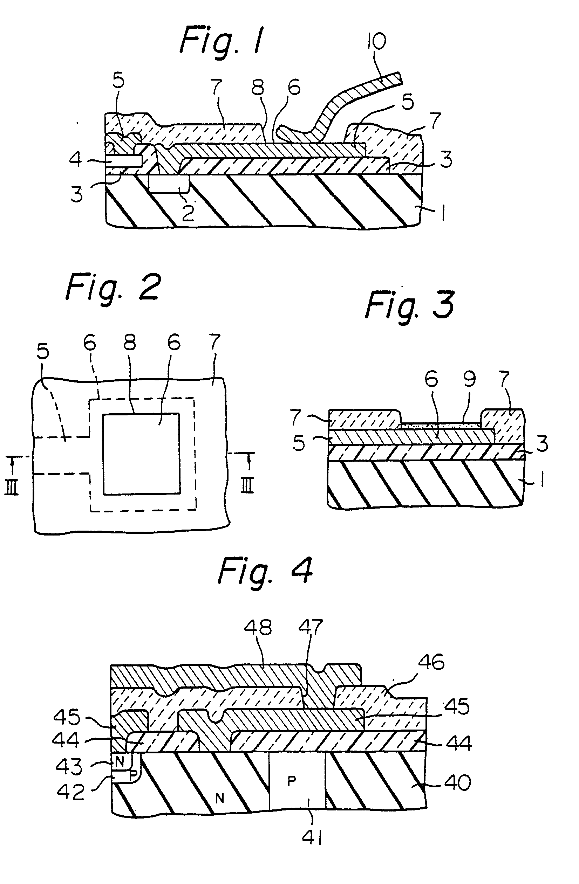

Figure 1 shows an example of a semiconductor device including a metal-oxide semiconductor field-effect transistor and wire bonding. In a silicon substrate 1, a source or drain 2 was formed by diffusion and the surface of the substrate 1 was covered with a silicon dioxide film 3 on which a gate 4 was formed. Then an approximately 1 μm thick aluminium layer 5 was deposited on the silicon dioxide film 3 and was patterned for use as interconnection line including a portion of an electrode pad 6. An approximately 1 μm to 2 μm thick PSG layer 7 was formed as a protective layer to cover the aluminium layer 5 and a 100 μm×100 μm opening 8 was made on the electrode pad 6 by dry etching. The dry etching in this example was reactive ion etching in which the reactive gas was $CHF_3$ and the pressure was 26.6 Pa (0.2 Torr). By carrying out dry etching, the PSG layer 7 was precisely etched, resulting in the formation of the precise opening 8.

A plan view of a portion of the electrode pad 6 at this stage, i.e. after dry etching, is shown in Figure 2, and a sectional view of the electrode pad 6 taken along the line III—III in Figure 2 is shown in Figure 3. After reactive ion etching, a phosphorus residue 9 remained in the opening 8 and on the surface of the electrode pad 6. The presence of the phosphorus residue 9 was confirmed by carrying out Auger analysis on a portion of the electrode pad 6. The amount of phosphorus residue on the surface of the electrode pad 6 was about 10 to 17 times that on the surface of an electrode pad fabricated in a manner similar to the above example but in which wet etching was carried out instead of dry etching. Then the surface of the electrode pad 6 was cleaned by dipping the silicon wafer in which the pad is formed in a 3.5 wt% aqueous solution of ammonia at a room temperature of about 22°C to 23°C for about 30 seconds. The phosphorus residue was removed from the surface of the electrode pad 6, for example, according to the following chemical reaction:

$$H_3PO_4+3NH_4OH\rightarrow(NH_4)_3PO_4+3H_2O$$

As the etching rate of aluminium when an ammonia solution is used is as slow as about 5 nm (50Å) per minute, the electrode pad 6 having a thickness of 1 μm was not effected by the above-mentioned short dipping time.

After the removal of the phosphorus residue from the surface of the electrode pad 6, a gold wire 10 was bonded onto the pad 6. The gold wire 10 alloyed well with the aluminium electrode pad 6, creating a highly reliable electrical connection between the gold wire 10 and the pad 6.

To ascertain the effect of the present invention, the purple plague test was carried out. The purple plague test was conducted by depositing a 150 nm (1500 Å) thick gold layer on the aluminium electrode pad 6 and annealing the gold layer and the pad 6 at 350°C for 15 minutes.

According to the purple plague test, if the gold alloys with the aluminium, the gold will change to a purple colour, indicating the formation of a gold-aluminium alloy. In the present test, the entire aluminium electrode pad 6, which was cleaned with an ammonia solution according to the present invention, turned purple in all the samples while only a small portion of an aluminium electrode pad similar to the pad 6 but not having been cleaned with an ammonia solution turned purple, i.e. about one tenth of the pad turned purple. Further, an aluminium electrode pad similar to the pad 6 but which was treated with a hydrofluoric acid solution instead of an ammonia solution did not change in colour at all. These results indicate that an excellent and reliable connection can be made between an electrode pad consisting of aluminium or another metal and being cleaned with an ammonia solution and a wire consisting of gold or another metal.

In addition to the above purple plague test, the phosphorus content of various electrode pads was determined by means of Auger analysis. Auger analysis, however, reveals the relative amount of phosphorus, not the absolute amount. In the following analysis the resultant amounts of phosphorus are expressed as a relative value on the basis of an assumed referential amount.

In the present carrying out of Auger analysis, first, a PSG layer covering the surface of an aluminium layer was wet etched with an aqueous hydrofluoric acid solution. Phosphorus was present on the surface of the aluminium layer in a relative value of 0.5 to 0.7. Next, a PSG layer covering the surface of an aluminium layer was reactive ion etched with a $CHF_3$, argon, or nitrogen reaction gas, the etching conditions being

maintained for some minutes after the completion of etching of the PSG layer. Phosphorus was present on the surface of the aluminium layer in a relative value of 7 to 8. (It should be noted that most practical semiconductor devices are subjected to over etching in order to eliminate on a metal layer the residue of a PSG layer to be etched). Then the aluminium layers which were subjected to the above reactive ion etching process were subjected to three types of cleaning treatments on the surface thereof. First, the aluminium layer was treated with an aqueous hydrofluoric acid solution. The relative value of phosphorus present on the surface of the aluminium layer was 1 to 1.5. Second, the aluminium layer was subjected to ion etching with an argon gas so as to etch the surface of the aluminium layer. The relative value of phosphorus present on the surface of the aluminium layer was 0.7 to 1.4. Third, the aluminium layer was treated with an aqueous ammonia solution. The relative value of phosphorus present on the surface of the aluminium layer was 0 to 0.2.

Figure 4 shows an example of a semiconductor device wherein a biopolar transistor is formed and a connection between two interconnection layers is made through a via hole. The bipolar transistor was formed by growing an N-type eptiaxial silicon layer 40 on a silicon substrate (not shown in Figure 4) having a diffused $N^+$-type buried layer (not shown in Figure 4) and by carrying out $P^+$-type, P-type and N-type diffusion to form an isolation region 41, a base 42, and an emitter 43, respectively. The surface of the epitaxial layer 40 was covered with a silicon dioxide layer 44. After opening windows in the silicon dioxide layer 44 to form some electrodes, an approximately 1 μm thick first aluminium layer 45 was deposited on the silicon dioxide layer 44 and in the windows and was patterned so as to make a first interconnection line. A PSG layer 46 having a 1 to 2 μm thickness was formed on the aluminium layer 45 and the silicon dioxide layer 44. A via hole 47 was then opened in the PSG layer 46 by parallel plane-type plasma etching using carbon tetrafluoride and oxygen as reaction gases, under a pressure of 108.6 Pa (0.8 Torr). By dry etching the via hole 47, having a diameter of 3 μm in the PSG layer 46, could be precisely formed, but a phosphorus residue was present on the surface of the aluminium layer 45 at the bottom of the via hole 47.

Then the surface of the aluminium layer 45 at the bottom of the via hole 47 was cleaned with an aqueous ammonia solution to remove the phosphorus residue from the via hole 47. The chemical reaction which occurred was similar to that described previously. After removal of the phosphorus residue, a second aluminium layer 48 was deposited on the silicon dioxide layer 44 and in the via hole 47. The obtained electrical connection between the first and second aluminium layers through a via hole was excellent and reliable and there was no contact failure. In comparison, connections similarly made but in which the surface of the first aluminium layer 45 at the bottom of the via hole 47 was not cleaned with an aqueous ammonia solution sometimes resulted in contact failure with the passage of time.

Satisfactory results are also obtained when the dry etching is reactive sputter etching. Satisfactory results are also obtained when the metal to be cleaned is an aluminium-based alloy, molybdenum, a molybdenum-based alloy, tungsten, a tungsten-based alloy, tantalum, a tantalum-based alloy, titanium, a titanium-based alloy, niobium, or a niobium-based alloy.

**Claims**

1. A process for fabricating a semiconductor device, comprising dry etching at least a part of a phosphosilicate glass layer on a metal layer on a semiconductor substrate to expose at least a part of the metal layer, characterised in that the exposed surface of the metal layer is treated with an alkaline solution.

2. A process according to claim 1 characterised in that an electrical connection is made onto the treated surface.

3. A process according to any preceding claim characterised in that the alkaline solution is a solution of ammonia or organic amine, or a salt of an organic amine.

4. A process according to to any preceding claim characterised in that the etching is parallel plane-type plasma etching, ion etching, or sputter etching.

5. A process according to any preceding claim characterised in that the metal layer essentially consists of a metal selected from aluminium, aluminium-based alloy, molybdenum, molybdenum-based alloy, tungsten, tungsten-based alloy, tantalum, tantalum-based alloy, titanium, titanium-based alloy, niobium, and niobium-based alloy.

**Patentansprüche**

1. Verfahren zur Herstellung einer Halbleitervorrichtung, mit Trockenätzung von wenigstens einem Teil von einer Phosphorsilikatglasschicht auf einer Metallschicht auf einem Halbleitersubstrat, um wenigstens einen Teil der Metallschicht zu exponieren, dadurch gekennzeichnet, daß die exponierte Oberfläche der Metallschicht mit einer alkalische Lösung behandelt wird.

2. Verfahren nach Anspruch 1, dadurch gekennzeichnet, daß einen elektrische Verbindung auf der behandelten Oberfläche hergestellt wird.

3. Verfahren nach einem der vorhergehenden Ansprüche, dadurch gekennzeichnet, daß die alkalische Lösung eine Lösung aus Ammoniak oder organischem Amin oder einem Salz von einem organischen Amin ist.

4. Verfahren nach einem der vorhergehenden Ansprüche, dadurch gekennzeichnet, das die alkalische Lösung eine Plasmaätzung vom Typ der parallelen Ebene, Ionenätzung oder Zerstäubungsätzung ist.

5. Verfahren nach einem der vorhergehenden Ansprüche, dadurch gekennzeichnet, daß die Metallschicht im wesentlichen besteht aus einem Metall, ausgewählt aus Aluminium, auf Aluminium basierender Legierung, Molybdän, auf molybdän basierender Legierung, Wolfram, auf Wolfram basierender Legierung, Tantal, auf Tantal basierender Legierung, Titan, auf Titan basierender Legierung, Niob und auf Niob basierender Legierung.

**Revendications**

1. Procédé de fabrication d'un dispositif semiconducteur, comprenant l'incision à sec d'au moins une partie d'une couche de verre au phosphosilicate se trouvant sur une couche métallique disposée sur un substrat semiconducteur afin d'exposer au moins une partie de la couche métallique, caractérisé en ce que la surface exposée de la couche métallique est traitée à l'aide d'une solution alcaline.

2. Procédé selon la revendication 1, caractérisé en ce qu'on établit une connexion électriuqe sur la surface traitée.

3. Procédé selon l'une quelconque des revendications précédentes, caractérisé en ce que la solution alcaline est une solution d'ammoniac ou d'amine organique, ou bien d'un sel d'une amine organique.

4. Procédé selon l'une quelconque des revendications précédentes, caractérisé en ce que l'incision est une incision par plasma à plansparallèles, une incision ionique, ou une incision par pulvérisation.

5. Procédé selon l'une quelconque des revendications précédentes, caractérisé en ce que la couche métallique est essentiellement constituée d'un métal choisi dans le groupe de l'aluminium, un alliage à base d'aluminium, le molybdène, un alliage à base de molybdène, le tungstène, un alliage à base de tungstène, le tantale, un alliage à base de tantale, le titane, un alliage à base de titane, le niobium et un alliage à base de niobium.

Fig. 1

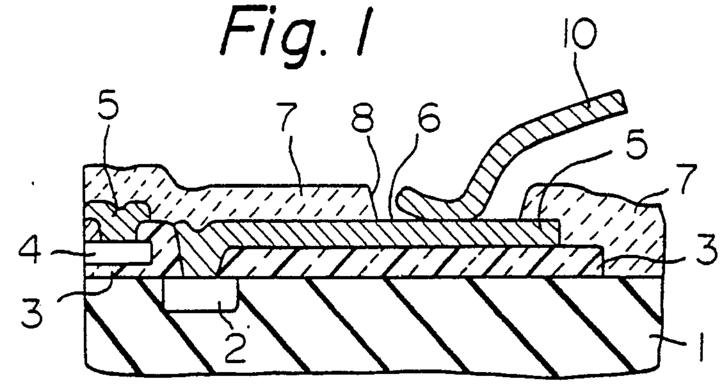


Fig. 2

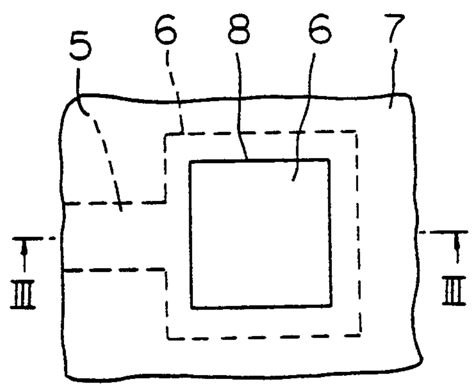


Fig. 3

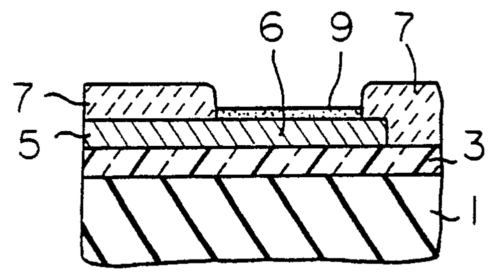


Fig. 4